# EUROPEAN PATENT APPLICATION

(11) **EP 1 094 596 A2**
(43) Date of publication of application: **25.04.2001**
(21) Application number: 00307584.3
(22) Date of filing: 04.09.2000
(51) Int. Cl.: H03D 3/00

(54) **Quadrature receiver with a vco controlled by the demodulated bit-rate**

(30) Priority: 09.09.1999 JP 25526299
(71) Applicant: ALPS ELECTRIC CO., LTD., Ota-ku Tokyo 145 (JP)
(72) Inventor: Kawai, Satoshi, C/o Alps Electric Co., Ltd., Tokyo 145 (JP)
(74) Representative: Kensett, John Hinton

(57) **Abstract**

A digitally modulated signal receiver includes an IQ demodulator (3) having two mixers (3a, 3b) into which a digitally modulated signal is input. A voltage-controlled local oscillator (4) inputs into the mixers a local oscillation signal having substantially the same frequency as the carrier frequency of the digitally modulated signal. A PLL circuit (10) outputs an error signal based on a reference frequency signal and the local oscillation signal. A low-pass filter (6, 7) smoothes the error signal and supplies a resulting control voltage to the local oscillator. The frequency of the reference frequency signal is changeable in the following manner. When the transmission rate of the digitally modulated signal is lower than a predetermined transmission rate, the frequency of the reference frequency signal is increased to be higher than a predetermined frequency. When the transmission rate of the digitally modulated signal is higher than the predetermined transmission rate, the frequency of the reference frequency signal is decreased to be lower than the predetermined frequency.

## Description

The present invention relates to a digitally modulated signal receiver for receiving digitally modulated signals, such as quaternary phase-shift keying (QPSK)-modulated television signals transmitted from a broadcast satellite.

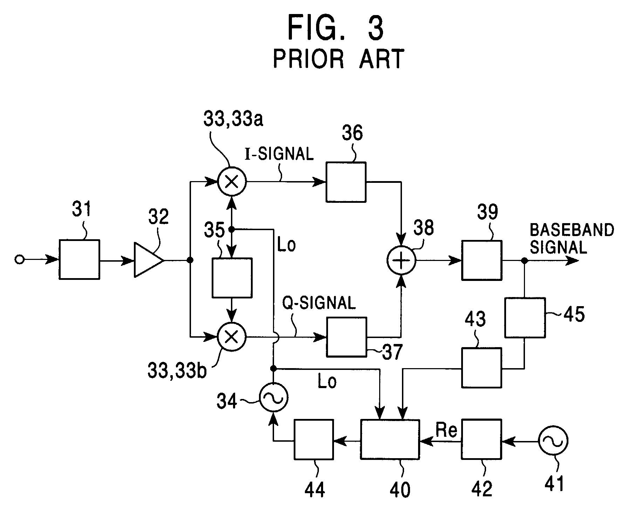

A typical conventional digitally modulated signal receiver, such as a digital television receiver for receiving QPSK-modulated television signals, is discussed below with reference to the block diagram of Fig. 3. A QPSK-modulated signal is first received by, for example, an outdoor parabolic antenna (not shown) and is converted into a signal of a frequency of approximately 1 to 2 GHz by a converter (not shown). The QPSK-modulated signal is then input into a band-pass filter 31 and is amplified in an amplifier 32. Thereafter, the amplified signal is input into a first mixer 33a and a second mixer 33b, which together form an IQ demodulator 33.

The digital television signal receiver shown in Fig. 3 includes a local oscillator 34 and a phase shifter 35. The local oscillator 34 outputs a local oscillation signal Lo having substantially the same frequency as a carrier frequency (in this case, the center frequency) of the QPSK-modulated signal. The phase shifter 35 shifts the phase of the local oscillation signal Lo by 90 degrees. The local oscillation signal Lo output from the local oscillator 34 is directly input into the first mixer 33a, while the oscillation signal output from the phase shifter 35, which is 90-degrees out of phase with the local oscillation signal Lo, is input into the second mixer 33b. An I-signal is output from the first mixer 33a, and a Q-signal whose phase is orthogonal to that of the I-signal is output from the second mixer 33b.

The I-signal and the Q-signal pass through low-pass filters 36 and 37, respectively, and are input into an adder 38. Since the carrier frequency and the local oscillation frequency of the digitally modulated signal are substantially the same, the frequency spectra of the I-signal and the Q-signal are half the frequency spectrum of the input digitally modulated signal (for example, approximately 27 MHz). Accordingly, the cut-off frequency of the low-pass filters 36 and 37 is about 13.5 MHz. The I-signal and the Q-signal are then added in the adder 38, and then, the resulting signal is demodulated into a baseband signal by a QPSK demodulator 39.

The oscillation frequency of the local oscillator 34 is controlled by a phase-locked loop (PLL) circuit 40. The PLL circuit 40 has a built-in variable scaler and a built-in phase comparator, neither of which is shown. A reference oscillation signal having a frequency of 4 MHz output from a reference oscillator 41 is scaled with a certain scaling factor by a scaler 42, thereby obtaining a reference frequency signal Re. The reference frequency signal Re is then input into the phase comparator of the PLL circuit 40, while the local oscillation signal Lo is scaled by the variable scaler and is input into the phase comparator.

In the phase comparator, the local oscillation signal Lo is compared with the reference frequency signal Re based on channel data D output from a central processing unit (CPU) 43. Upon comparison, an error voltage based on a difference between the local oscillation signal Lo and the reference frequency signal Re is output from the phase comparator. The error voltage is smoothed by a low-pass filter 44 and is supplied to the local oscillator 34 as a control voltage, which is then used for controlling the local oscillation frequency so that it can be determined by the channel data D. The frequency data of the digitally modulated signal is detected from the baseband signal by using a frequency detection circuit 45, and is input into the CPU 43, in which it is further superimposed on the channel data D. As a result, if the frequency of the digitally modulated signal deviates, the local oscillation frequency is automatically corrected according to the deviation, so that the frequency of the input digitally modulated signal always coincides with the local oscillation signal.

The transmission rates of digitally modulated signals, such as QPSK-modulated signals, are not the same and vary from a comparatively low bit rate, such as 10 Mbps or lower, to a relatively high bit rate, such as 40 Mbps or higher. Different transmission rates are set according to the system (broadcast satellite (BS) or a communication satellite (CS)) or the channel from which the digitally modulated signals are transmitted.

Upon comparing the high-bit-rate digitally modulated signals and the low-bit-rate digitally modulated signals, the low-bit-rate digitally modulated signals are more vulnerable to phase noise of the local oscillation signal Lo since they have a narrower frequency spectrum. Thus, bit errors are more likely to occur as the phase noise becomes higher.

Meanwhile, the phase noise contained in the local oscillation signal Lo is closely related to the frequency of the reference frequency signal Re to be input into the PLL circuit 40. The phase noise contained in the local oscillation signal Lo becomes higher with a lower frequency of the reference frequency signal Re.

Accordingly, in order to prevent the occurrence of bit errors when the low-bit-rate digitally modulated signals are received, the scaling factor of the scaler 42 is set to be 4, thereby increasing the frequency of the reference frequency signal Re to as high as 1 MHz. Simultaneously, the time constant of the low-pass filter 44 is decreased so as to increase the loop speed of the PLL circuit 40.

In conventional digitally modulated signal receivers, as discussed above, the local oscillation frequency is corrected by the PLL circuit 40 so that the frequency of the input digitally modulated signal matches the local oscillation frequency. However, the minimum correcting increment (step frequency) of the local oscillation frequency is equal to the frequency of the reference frequency signal (1 MHz). Thus, in correcting for a deviation of the frequency of the digitally modulated signal by the PLL circuit 40, the local oscillation frequency is changed by at least 1 MHz.

If the local oscillation frequency is corrected in receiving the high-bit-rate digitally modulated signals, the QPSK demodulation is temporarily out of synchronization since the loop speed of the PLL circuit 40 is high. Because of a wide frequency spectrum of the high-bit-rate digitally modulated signals, the spectra of the I-signal and the Q-signal partially deviate from the pass bands of the low-pass filters 36 and 37, respectively, unless the local oscillation frequency is appropriately corrected, and accordingly, some signal components are lost. As a result, the correction of the bit error rate cannot be made, thus failing to reproduce a correct image, resulting in a so-called mosaic image.

Accordingly, it is an object of the present invention to provide a digitally modulated signal receiver for correctly receiving QPSK-modulated signals without causing the QPSK demodulation from becoming out of synchronization even when the local oscillation frequency is corrected by a PLL circuit in receiving a high-bit-rate digitally modulated signal.

In order to achieve the above object, according to the present invention, there is provided a digitally modulated signal receiver including an IQ demodulator having two mixers into which a digitally modulated signal is input. A voltage-controlled local oscillator inputs into the two mixers a local oscillation signal having a frequency which is substantially identical to a carrier frequency of the digitally modulated signal. A PLL circuit outputs an error signal based on a reference frequency signal and the local oscillation signal. A low-pass filter smoothes the error signal and supplies a resulting control voltage to the voltage-controlled local oscillator. The frequency of the reference frequency signal is changeable in such a manner that it is increased to be higher than a predetermined frequency when the transmission rate of the digitally modulated signal is lower than a predetermined transmission rate, and it is decreased to be lower than the predetermined frequency when the transmission rate of the digitally modulated signal is higher than the predetermined transmission rate.

With this arrangement, even when the oscillation frequency of the local oscillator is corrected in receiving, particularly, high-bit-rate digitally modulated signals, the frequency spectra of the high-bit-rate I-signal and Q-signal do not deviate from the pass bands of the low-pass filter. As a result, the bit error rate is not increased.

In the aforementioned digitally modulated signal receiver, the time constant of the low-pass filter may be changeable in such a manner that it is decreased to be smaller than a predetermined time constant when the transmission rate of the digitally modulated signal is lower than the predetermined transmission rate, and it is increased to be larger than the predetermined time constant when the transmission rate of the digitally modulated signal is higher than the predetermined transmission rate. It is thus possible to stably output the control voltage in accordance with the loop speed of the PLL circuit.

The above-described digitally modulated signal receiver may further include a reference oscillator for outputting a reference oscillation signal, and a variable scaler for scaling the frequency of the reference oscillation signal. The reference frequency signal may be output from the variable scaler, and the scaling factor of the variable scaler may be changed according to whether the transmission rate of the digitally modulated signal is high or low. Accordingly, the frequency of the reference frequency signal can easily be changed.

According to the aforementioned digitally modulated signal receiver, the low-pass filter may include a resistor unit and a capacitor which is connected between one end of the resistor unit and a ground, and the time constant may be changed by varying the capacitance of the capacitor. Consequently, the time constant can easily be changed.

In the above-described digitally modulated signal receiver, the capacitor may include a plurality of capacitor devices, and a switching unit may be opened or closed to connect or disconnect one of the capacitor devices to a ground. It is thus possible to easily change the time constant.

The aforementioned digitally modulated signal receiver may further include a channel selection unit for inputting channel data for specifying a channel of the digitally modulated signal into the PLL circuit. The switching unit may include a transistor. The channel selection unit may output, together with the channel data, determination data for determining whether the transmission rate of the channel is higher or lower than the predetermined transmission rate. The PLL circuit may include a channel decoder for outputting a binary signal based on the determination data, and according to the binary signal, the transistor may be controlled to be on or off, and the scaling factor of the variable scaler may be changed. Thus, by performing the channel-selecting operation, the frequency of the reference frequency signal and the time constant of the low-pass filter can be automatically changed.

Embodiments of the present invention will now be described, by way of example, with reference to the accompanying diagrammatic drawings, in which:
Fig. 1 is a block diagram illustrating a digitally modulated signal receiver according to an embodiment of the present invention;
Fig. 2 is a circuit diagram illustrating a low-pass filter used in the digitally modulated signal receiver shown in Fig. 1; and
Fig. 3 is a block diagram illustrating a conventional digitally modulated signal receiver.

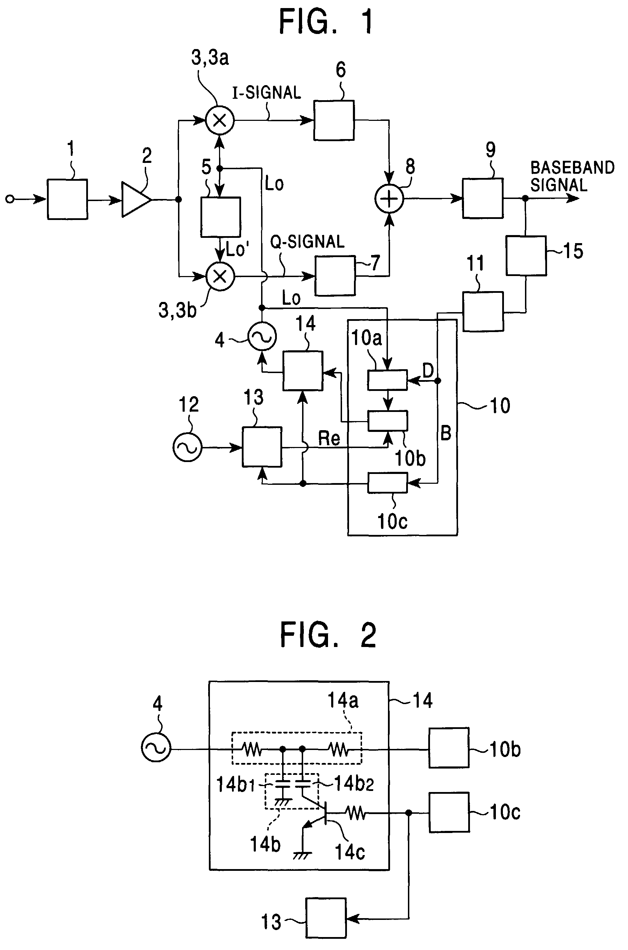

A digitally modulated signal receiver according to an embodiment of the present invention is discussed below, with reference to the block diagram of Fig. 1, in the context of a digital television receiver for receiving QPSK-modulated television signals. A QPSK-modulated signal is received by an outdoor parabolic antenna (not shown) and is frequency-converted into a signal of about 1 to 2 GHz by an outdoor converter (not shown). The QPSK-modulated signal is then input into a band-pass filter 1 and is amplified in an amplifier 2. Thereafter, the amplified signal is input into a first mixer 3a and a second mixer 3b, which together form an IQ demodulator 3.

The digital television receiver shown in Fig. 1 includes a local oscillator 4 and a phase shifter 5. The local oscillator 4 outputs a local oscillation signal Lo having substantially the same frequency as a carrier frequency (in this case, the center frequency) of the QPSK-modulated signal. The phase shifter 5 shifts the phase of the local oscillation signal Lo by 90 degrees. The local oscillator 4 is formed of a voltage controlled oscillator in which the oscillation frequency is controlled by the control voltage. The local oscillation signal Lo output from the local oscillator 4 is directly input into the first mixer 3a, while a local oscillation signal Lo', which is 90-degrees out of phase with the local oscillation signal Lo, is input into the second mixer 3b. An I-signal is output from the first mixer 3a, and a Q-signal whose phase is orthogonal to (90-degrees out of phase with) the I-signal is output from the second mixer 3b.

The I-signal and the Q-signal pass through low-pass filters 6 and 7, respectively, and are input into an adder 8. Since the carrier frequency of the digitally modulated signal and the local oscillation frequency are substantially the same, the frequency spectra of the I-signal and the Q-signal are half the frequency spectrum of the input digitally modulated signal (for example, approximately 27 MHz). Accordingly, the cut-off frequency of the low-pass filters 6 and 7 is about 13.5 MHz. The I-signal and the Q-signal are added in the adder 8, and then, the resulting signal is demodulated into a baseband signal by a QPSK demodulator 9.

The oscillation frequency of the local oscillator 4 is controlled by a PLL circuit 10. The PLL circuit 10 contains a variable scaler 10a, a phase comparator 10b, and a channel decoder 10c. The local oscillation signal Lo is scaled by the variable scaler 10a, and is input into the phase comparator 10b. The scaling factor of the variable scaler 10a is set by channel data D output from a CPU 11, which serves as a channel selection unit. Meanwhile, a reference oscillation signal of 4 MHz output from a reference oscillatar 12 is scaled by a variable scaler 13, resulting in a reference frequency signal Re, which is then input into the phase comparator 10b.

Determination data B for determining whether the bit rate of a digitally modulated signal corresponding to the received channel is higher or lower than a predetermined bit rate is added to the channel data D in advance. The determination data B, which is used for switching the time constant of a low-pass filter 14, is input into the channel decoder 10c.

Then, the reference frequency signal Re and the local oscillation signal Lo scaled by the variable scaler 10a are compared by the phase comparator 10b. Upon comparison, an error voltage based on a difference between the two signals is output from the phase comparator 10b. The error voltage is smoothed by the low-pass filter 14, in which the time constant is variable, and is supplied to the local oscillator 4 as a control voltage, which is then used for controlling the local oscillation frequency so that it can be determined by the channel data D. The frequency data of the digitally modulated signal is contained in the baseband signal, and is thus detected from the baseband signal by a frequency detection circuit 15 and is input into the CPU 11, in which it is further superimposed on the channel data D. As a result, if the frequency of the digitally modulated signal deviates, the local oscillation frequency is automatically corrected in correspondence with the deviation, so that the frequency of the input digitally modulated signal always coincides with the local oscillation frequency.

The channel decoder 10c within the PLL circuit 10 outputs binary values, i.e., a high level or a low level, according to the determination data B. The scaling factor of the variable scaler 13 and the time constant of the low-pass filter 14 can be changed by the binary values. More specifically, when the determination data B indicates a low bit rate, the channel decoder 10c outputs, for example, the low level, thereby setting the scaling factor of the variable scaler 13 to be, for example, 4 and decreasing the time constant of the low-pass filter 14. As a consequence, the frequency of the reference frequency signal Re output from the variable scaler 13 is increased to 1 MHz, which decreases the phase noise, thereby reducing the bit error rate when demodulating the QPSK-modulated signal. Additionally, since the time constant of the low-pass filter 14 is decreased in accordance with the reference frequency signal Re, the loop speed of the PLL circuit 10 can be increased.

On the other hand, when the determination data B indicates a high bit rate, the channel decoder 10c outputs, for example, a high level, thereby setting the scaling factor of the variable scaler 13 to be, for example, 64 and increasing the time constant of the low-pass filter 14. As a consequence, the frequency of the reference frequency signal Re output from the variable scaler 13 is 62.5 KHz, so that the step frequency of the local oscillator 4 is also decreased to as low as 62.5 KHz. Accordingly, with a low loop speed of the PLL circuit 10, the oscillation frequency of the local oscillator 4 can be corrected without causing the QPSK demodulation from becoming out of synchronization. This prevents a deviation of the frequency spectra of the I-signal and the Q-signal from the pass bands of the low-pass filters 6 and 7, respectively. As a result, the bit error rate is not increased.

If the ratio of the frequency of the reference frequency signal to be changed by the variable scaler 13 when the low-bit-rate digitally modulated signal is received to that when the high-bit-rate digitally modulated signal is received is not so large, the time constant may remain the same without being switched regardless of whether the high-bit-rate signal or the low-bit-rate signal is received.

Fig. 2 illustrates an example of the specific configuration of the low-pass filter 14. The low-pass filter 14 includes a resistor unit 14a which is connected in series between the phase comparator 10b and the local oscillator 4, and a capacitor 14b for shunting one end of the resistor unit 14a to a ground. The capacitor 14b is formed of two capacitor devices 14b₁ and 14b₂, and the capacitor device 14b₂ is connected to the collector of a transistor 14c, which serves as a switching unit. The emitter of the transistor 14c is connected to a ground.

The transistor 14c is controlled to be on or off according to an output of the channel decoder 10c. When the output of the channel decoder 10c is at the high level, the transistor 14c is switched on (conducted) between the collector and the emitter, grounding the capacitor device 14b₂, thereby increasing the time constant of the low-pass filter 14. In contrast, when the output of the channel decoder 10c is at the low level, the transistor 14c is switched off (non-conducted) between the collector and the emitter, so that the capacitor device 14b₂ is ungrounded, thereby decreasing the time constant of the low-pass filter 14.

## Claims

1. A digitally modulated signal receiver comprising:
an IQ demodulator including two mixers into which a digitally modulated signal is input;
a voltage-controlled local oscillator for inputting into said two mixers a local oscillation signal having a frequency which is substantially identical to a carrier frequency of the digitally modulated signal;
a phase-locked loop circuit for outputting an error signal based on a reference frequency signal and the local oscillation signal; and
a low-pass filter for smoothing the error signal and for supplying a resulting control voltage to said voltage-controlled local oscillator,
wherein the frequency of the reference frequency signal is changeable in such a manner that it is increased to be higher than a predetermined frequency when a transmission rate of the digitally modulated signal is lower than a predetermined transmission rate, and it is decreased to be lower than the predetermined frequency when the transmission rate of the digitally modulated signal is higher than the predetermined transmission rate.

2. A digitally modulated signal receiver according to claim 1, wherein a time constant of said low-pass filter is changeable in such a manner that it is decreased to be smaller than a predetermined time constant when the transmission rate of the digitally modulated signal is lower than the predetermined transmission rate, and it is increased to be larger than the predetermined time constant when the transmission rate of the digitally modulated signal is higher than the predetermined transmission rate.

3. A digitally modulated signal receiver according to claim 1 or 2, further comprising:
a reference oscillator for outputting a reference oscillation signal; and
a variable scaler for scaling the frequency of the reference oscillation signal,
wherein the reference frequency signal is output from said variable scaler, and a scaling factor of said variable scaler is changed according to whether the transmission rate of the digitally modulated signal is higher or low.

4. A digitally modulated signal receiver according to claim 1, 2 or 3, wherein said low-pass filter comprises resistor means and capacitor means which is connected between one end of said resistor means and a ground, and the time constant is changed by varying a capacitance of said capacitor means.

5. A digitally modulated signal receiver according to claim 4, wherein said capacitor means comprises a plurality of capacitor devices, and switching means is opened or closed to connect or disconnect one of said capacitor devices to ground.

6. A digitally modulated signal receiver according to any preceding claim, further comprising channel selection means for inputting channel data for specifying a channel of the digitally modulated signal into said phase-locked loop circuit, wherein said switching means comprises a transistor, said channel selection means outputs, together with the channel data, determination data for determining whether the transmission rate of the channel is higher or lower than the predetermined transmission rate, said phase-locked loop circuit comprises a channel decoder for outputting a binary signal based on the determination data, and according to the binary signal, said transmission is controlled to be on or off, and the scaling factor of said variable scaler is changed.
